# EUROPEAN PATENT APPLICATION

(11) **EP 4 542 248 A1**
(43) Date of publication of application: **23.04.2025**
(21) Application number: 23842796.7
(22) Date of filing: 29.06.2023
(51) Int. Cl.: G01R 33/02

(54) **MAGNETIC DETECTOR**

(30) Priority: 21.07.2022 JP 2022116491
(71) Applicant: Aichi Steel Corporation, Tokai-shi, Aichi 476-8666 (JP)
(72) Inventor: ITABUCHI, Shiori, Tokai-shi, Aichi 476-8666 (JP); KAWANO, Takeshi, Tokai-shi, Aichi 476-8666 (JP)
(74) Representative: Kramer Barske Schmidtchen Patentanwälte PartG mbB
(86) International application number: PCT/JP2023/024184
(87) International publication number: WO 2024/018869

(57) **Abstract**

A magnetic detector (1,2) includes: a magneto-impedance sensor element (10) including a magnetosensitive body (11) configured to cause a magnetization change in response to a strength of a magnetic field when an excitation current I_{IN} is supplied to this body, and a detection coil (12) wound around the magnetosensitive body (11) and configured to output an induced voltage generated by the magnetization change in the magnetosensitive body (11); a sample hold circuit (22, 32) connected to one end of the detection coil (12) and is configured to hold an output voltage of the detection coil (12) when a sampling switch is tuned on; an amplifier circuit (24, 33) connected to an output side of the sample hold circuit (22, 32); and a post-stage high-pass filter (25, 35) connected to an output side of the amplifier circuit (24, 33).

## Description

### TECHNICAL FIELD

The present invention relates to a magnetic detector.

### BACKGROUND ART

Patent Literatures 1 and 2 disclose a magnetic detector using an amorphous magnetic wire as a magnetosensitive body and a detection coil to detect the magnetic field strength to be detected. The amorphous magnetic wire has a property capable of generating a magneto-impedance effect (MI effect). That is, the amorphous magnetic wire has a property capable of causing a magnetization change in response to a strength of the magnetic field acting on the amorphous magnetic wire when an excitation current is supplied thereto. More specifically, in the amorphous magnetic wire, the circumferential permeability changes in response to the magnetic field strength acting on the wire, whereby the impedance of the wire changes. The amorphous magnetic wire has a detection coil wound around it, and the detection coil outputs an induced voltage generated by the magnetization change in the amorphous magnetic wire.

The excitation current supplied to the amorphous magnetic wire is, for example, a pulse current or a high-frequency current. When a pulse current or a high-frequency current is supplied to the amorphous magnetic wire, the amorphous magnetic wire causes a magnetization change corresponding to the strength of the magnetic field acting thereon in at the timing of current rise. At this time, an induced voltage due to the magnetization change in the amorphous magnetic wire is generated in the detection coil.

In order to detect the induced voltage generated in the detection coil, a detection circuit is connected to the detection coil. Patent Literature 1 discloses a configuration in which a detection circuit includes a sample hold circuit and an amplifier circuit. The sample hold circuit includes a sampling switch configured to be turned on in response to the timing of supply of an excitation current, and a hold capacitor configured to maintain an output during turning on the sampling switch. The amplifier circuit is connected to the output side of the sample hold circuit.

Patent Literature 2 discloses a configuration in which a detection circuit includes a sample hold circuit, an amplifier circuit, and a feedback circuit. The feedback circuit is configured to connect an output terminal of the amplifier circuit and one end of a detection coil and to magnetically apply negative feedback. Therefore, in a state where the DC component of the magnetic field acts on the amorphous magnetic wire, a feedback current flows through the detection coil, thereby enabling to generate a feedback magnetic field capable of canceling out the DC component of the magnetic field.

### PRIOR ART LITERATURE

### Patent Literature

Patent Literature 1: JP 2000-258517 A
Patent Literature 2: JP 5924503 B

### SUMMARY OF INVENTION

### PROBLEMS TO BE SOLVED BY INVENTION

There is a demand for further enhancement of the magnetic field detection performance, and in particular, there is a demand for detection of a minute AC magnetic field (e.g., of several nT) under a large DC magnetic field (e.g., of several hundred µT) such as geomagnetism or a substance that exhibits ferromagnetism.

Here, it has been found that the output value of the detection circuit disclosed in Patent Literatures 1 and 2 varies depending on the magnitude of the DC magnetic field. The larger the magnitude of the DC magnetic field, the larger the output value of the detection circuit tends to be. Therefore, the output value of the detection circuit is desired to be less susceptible to the influence of the DC magnetic field.

The present invention has been made in view of such a background, and is intended to provide a magnetic detector capable of enhancing magnetic field detection performance by making the output value of a detection circuit less susceptible to a DC magnetic field.

### MEANS FOR SOLVING PROBLEM

An aspect of the present invention is a magnetic detector including:
a magneto-impedance sensor element including: a magnetosensitive body configured to cause a magnetization change in response to a strength of a magnetic field when an excitation current is supplied; and a detection coil wound around the magnetosensitive body and configured to output an induced voltage generated by the magnetization change in the magnetosensitive body;
a sample hold circuit connected to one end of the detection coil and configured to hold an output voltage of the detection coil during turning on a sampling switch;
an amplifier circuit connected to an output side of the sample hold circuit; and
a post-stage high-pass filter connected to an output side of the amplifier circuit.

### EFFECTS OF INVENTION

According to the above-described magnetic detector, even if an offset component affected by the DC magnetic field is included in the output of the amplifier circuit, the offset component can be removed by the post-stage high-pass filter. Accordingly, the output value of the detection circuit can be made free of the offset component affected by the DC magnetic field. As a result, the detection circuit is less susceptible to the DC magnetic field, and is capable of detecting a minute AC magnetic field with high accuracy.

As described above, according to the above-described aspect, the output value of the detection circuit is made to be less susceptible to the influence of the DC magnetic field, thereby enabling to provide the magnetic detector capable of enhancing magnetic field detection performance.

### BRIEF DESCRIPTION OF DRAWINGS

Fig. 1 is a diagram illustrating a configuration of a magnetic detector in Embodiment 1.
Fig. 2(a) is a diagram illustrating an ideal behavior in a configuration of the magnetic detector in Embodiment 1, in which no post-stage high-pass filter is provided. Fig. 2(b) is a diagram illustrating an actual behavior in the configuration of the magnetic detector in Embodiment 1, in which no post-stage high-pass filter is provided. Fig. 2(c) is a diagram illustrating a behavior of the magnetic detector in Embodiment 1.
Fig. 3 is a diagram describing an operation of a sample hold circuit.
Fig. 4 is a diagram illustrating a relationship between the output values of the detection circuit in Figs. 2(b) and 2(c) and a DC magnetic field.
Fig. 5 is a diagram illustrating a configuration of a magnetic detector in Embodiment 2.
Fig. 6(a) is a diagram illustrating an ideal behavior in a configuration of the magnetic detector in Embodiment 2, in which no post-stage high-pass filter is provided; Fig. 6(b) is a diagram illustrating an actual behavior in a configuration of the magnetic detector in Embodiment 2, in which no post-stage high-pass filter is provided; and Fig. 6(c) is a diagram illustrating the behavior of the magnetic detector in Embodiment 2.
Fig. 7 is a diagram illustrating a relationship between the output values of the detection circuit in Figs. 6(b) and 6(c) and a DC magnetic field.
Fig. 8 is a diagram illustrating a configuration of a magnetic detector in a first modification of Embodiment 1.
Fig. 9 is a diagram illustrating a configuration of a magnetic detector in a second modification of Embodiment 1.
Fig. 10 is a diagram illustrating a configuration of a magnetic detector in a third modification of Embodiment 1.

### MODE FOR CARRYING OUT INVENTION

The magnetic detector can be applied to various applications with the purpose of detecting the strength of a magnetic field. For example, the magnetic detector can be used in an electronic compass, a foreign object detection sensor, a magnetic positioning system, or the like.

In the magnetic detector, a magnetic wire, particularly, an amorphous magnetic wire can be used as the magnetosensitive body included in the magneto-impedance sensor element. Note that, as the magnetosensitive body, a material other than the amorphous magnetic wire can be used as long as the material has a property capable of causing changes in magnetization in response to the strength of the magnetic field when an excitation current is supplied. Incidentally, as the excitation current supplied to the magnetosensitive body, for example, a periodic current such as a pulse current or a high-frequency current can be used.

A first aspect may be an aspect in which the magnetic detector further includes a pre-stage high-pass filter connected to an output side of the sample hold circuit, and the amplifier circuit is connected to an output side of the pre-stage high-pass filter.

In this case, the magnetic detector is configured to include a magneto-impedance sensor element, a sample hold circuit, a pre-stage high-pass filter, an amplifier circuit, and a post-stage high-pass filter. It was thought that all of the components influenced by the DC magnetic field were able to be removed by the pre-stage high-pass filter. It has been found that, however, even through the pre-stage high-pass filter, all of the components influenced by the DC magnetic field were not able to be removed by the pre-stage high-pass filter, and the components influenced by the DC magnetic field were included in the components having passed through the pre-stage high-pass filter. Nevertheless, the components influenced by the DC magnetic field included in the component having passed through the pre-stage high-pass filter can be removed by a post-stage high-pass filter. Therefore, it is possible to create a state where the components influenced by the DC magnetic field are not included in the detection value of the detection circuit.

In particular, it is preferable that the sample hold circuit is configured to hold output voltage variation of the detection coil during turning on the sampling switch, the amplifier circuit is configured to perform integral processing and amplification processing on the output of the pre-stage high-pass filter, and to convert the output voltage variation into an offset component through the integral processing, and the post-stage high-pass filter is configured to remove the offset component.

The relationship between an on-operation of the sampling switch and the output of the detection coil creates a state where the components influenced by the DC magnetic field (the offset component) are included in the components having passed through the pre-stage high-pass filter. Even with such a configuration, the post-stage high-pass filter can reliably remove the offset component.

It is also preferable that the sample hold circuit is configured to hold output voltage variation at at least one of an acquisition time or a settling time caused by on-off operation of the sampling switch, the amplifier circuit is configured to perform integral processing and amplification processing on an output of the pre-stage high-pass filter, and to convert the output voltage variation into an offset component through the integral processing, and the post-stage high-pass filter is configured to remove the offset component.

The on-off operation of the sampling switch creates a state where the components influenced by the DC magnetic field (the offset component) are included in the component having passed through the pre-stage high-pass filter. Even with such a configuration, the post-stage high-pass filter can reliably remove the offset component.

Moreover, in the magnetic detector of the first aspect, the output side of the amplifier circuit and one end of the detection coil are not connected, and no feedback circuit is provided therebetween.

In the magnetic detector of the second aspect, an output side of the amplifier circuit may be connected to one end of the detection coil and a feedback circuit including a low-pass filter is further provided. In this case, the magnetic detector is configured to include a magneto-impedance sensor element, a sample hold circuit, an amplifier circuit, a feedback circuit, and a post-stage high-pass filter.

According to this configuration, for example, when a minute AC magnetic field is desired to be detected under a large DC magnetic field, the magneto-impedance sensor element is less susceptible to the DC magnetic field, and is capable of outputting an induced voltage generated by the influence of the minute AC magnetic field. Accordingly, the detection range of the magneto-impedance sensor element can be effectively utilized.

In particular, in this configuration, the feedback circuit is configured such that the external magnetic field applied to the magneto-impedance sensor element is partially cancelled out by a feedback magnetic field caused by a feedback current in a predetermined frequency band passing through the low-pass filter, and the sample hold circuit is caused to hold a total voltage that is the sum of the induced voltage and a feedback voltage caused by the feedback current. Here, the post-stage high-pass filter is preferably configured to remove a component included in the output of the amplifier circuit, which is the component of the feedback voltage caused by the feedback current.

In the magnetic detector of the first aspect and the second aspect, the post-stage high-pass filter can include any one of the group consisting of: a circuit including at least two components of inductance(L)-capacitance(C)-resistance(R) (LCR); a high-pass filter circuit including an operational amplifier; an arithmetic processing unit configured to perform digital signal processing after digital conversion; a processing unit where a component in a predetermined frequency band obtained by passing an output of the amplifier circuit through a low-pass filter is subtracted from the output of the amplifier circuit; and a reference voltage correction unit configured to supply a DC component out of the output of the amplifier circuit as a reference voltage to the amplifier circuit. Any of the configuration can suppress the influence of the DC magnetic field. Note that, examples of the circuit including at least two components of LCR include a CR circuit, an RL circuit, an LC circuit, and an RLC circuit.

### (Embodiment 1)

### 1-1. Configuration of magnetic detector 1

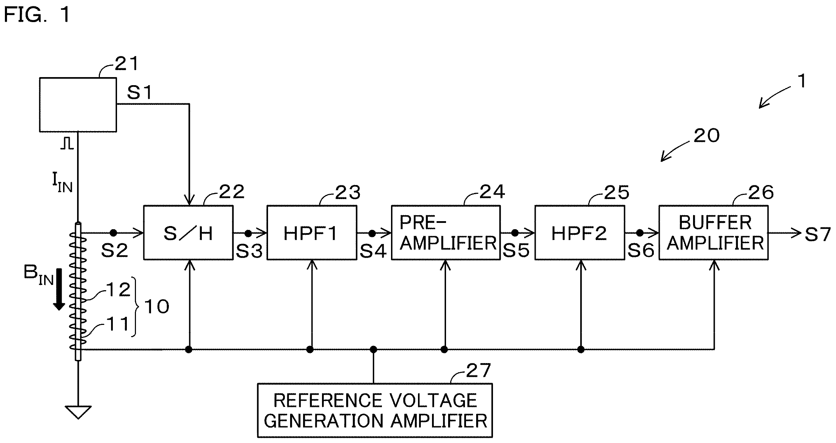

A configuration of a magnetic detector 1 in Embodiment 1 will be described with reference to Fig. 1. As illustrated in Fig. 1, the magnetic detector 1 according to the present embodiment includes a magneto-impedance sensor element 10 (hereinafter, referred to as an "MI sensor element") and a detection circuit 20.

The MI sensor element 10 is configured to output a voltage corresponding to the strength of a magnetic field B_{IN} acting on the MI sensor element 10. The MI sensor element 10 includes a magnetosensitive body 11 and a detection coil 12.

When an excitation current I_{IN} is supplied to the magnetosensitive body 11, the magnetosensitive body 11 causes a magnetization change in response to the strength of the magnetic field B_{IN} acting thereon. Specifically, when a pulse current or a high frequency current, as the excitation current I_{IN}, is supplied to the magnetosensitive body 11, the circumferential permeability thereof changes in response to the strength of the magnetic field B_{IN} acting thereon and thereby the impedance of the magnetosensitive body 11 changes. That is, when the excitation current I_{IN} is supplied to the magnetosensitive body 11 in a state where the magnetic field B_{IN} is acting on the magnetosensitive body 11, the magnetosensitive body 11 causes the magnetization change. As the magnetosensitive body 11, for example, a magnetic wire, in particular, an amorphous magnetic wire is used.

The detection coil 12 is wound around the magnetosensitive body 11. When the magnetic field B_{IN} acts on the magnetosensitive body 11, and the excitation current I_{IN} is supplied thereto, a magnetization change in the magnetosensitive body 11 generates an induced voltage in the detection coil 12. Accordingly, the detection coil 12 outputs the induced voltage generated by the magnetization change in the magnetosensitive body 11.

The detection circuit 20 is electrically connected to the MI sensor element 10, and is configured to detect the strength of the magnetic field B_{IN} acting on the magnetosensitive body 11. The detection circuit 20 includes an excitation circuit 21, a sample hold circuit 22 ("S/H" in Fig. 1), a pre-stage high-pass filter 23 ("HPF1" in Fig. 1), a preamplifier 24, a post-stage high-pass filter 25 ("HPF2" in Fig. 1), a buffer amplifier 26, and a reference voltage generation amplifier 27.

The excitation circuit 21 is configured to supply a pulse current or a high-frequency current as the excitation current I_{IN} to the magnetosensitive body 11. Furthermore, the excitation circuit 21 is configured to output a signal S1 to hold the induced voltage of the detection coil 12 in synchronization with the supply of the excitation current I_{IN}. The sample hold circuit 22 is connected to one end of the detection coil 12 and is configured to include a sampling switch and a hold capacitor. The sampling switch of the sample hold circuit 22 is turned on or off based on the signal S1 outputted from the excitation circuit 21. Thus, the sample hold circuit 22 is configured to hold the output voltage of the detection coil 12 during turning on the sampling switch.

The pre-stage high-pass filter 23 is connected to the output side of the sample hold circuit 22 and is configured to extract a signal in a frequency band higher than a predetermined frequency band. As the pre-stage high-pass filter 23, for example, a known high-pass filter circuit such as a circuit using at least two components of LCR or a circuit using an operational amplifier such as a differential circuit can be used. Furthermore, as the pre-stage high-pass filter 23, besides the above-described circuits, other configurations can also be used as long as they are capable of achieving the intended function.

The preamplifier 24 is an amplifier circuit to be connected to the output side of the pre-stage high-pass filter 23. The preamplifier 24 performs integral processing and amplification processing on the output of the pre-stage high-pass filter 23.

The post-stage high-pass filter 25 is connected to the output side of the preamplifier 24 and is configured to extract a signal in a frequency band higher than a predetermined frequency band. As the post-stage high-pass filter 25, for example, a known high-pass filter circuit such as a circuit including at least two components of LCR or a circuit using an operational amplifier such as a differential circuit can be used. Furthermore, as the post-stage high-pass filter 25, besides the above-described circuits, other configurations can also be used as long as they are capable of achieving the intended function.

The buffer amplifier 26 is an amplifier circuit to be connected to the output side of the post-stage high-pass filter 25. The buffer amplifier 26 performs amplification processing on the output of the post-stage high-pass filter 25. An output of the buffer amplifier 26 is the output of the detection circuit 20. The reference voltage generation amplifier 27 is a circuit configured to generate a reference voltage for the MI sensor element 10, the sample hold circuit 22, the pre-stage high-pass filter 23, the preamplifier 24, the post-stage high-pass filter 25, and the buffer amplifier 26. For example, when the output voltage of the detection circuit 20 is in the range of from 0 V to 5 V, the reference voltage is set to 2.5 V as the median value within the range.

Here, the magnetic detector 1 of the present embodiment is configured such that the output side of the preamplifier 24 and one end of the detection coil 12 are not connected, and no feedback circuit is provided therebetween.

### 1-2. Operation of magnetic detector 1

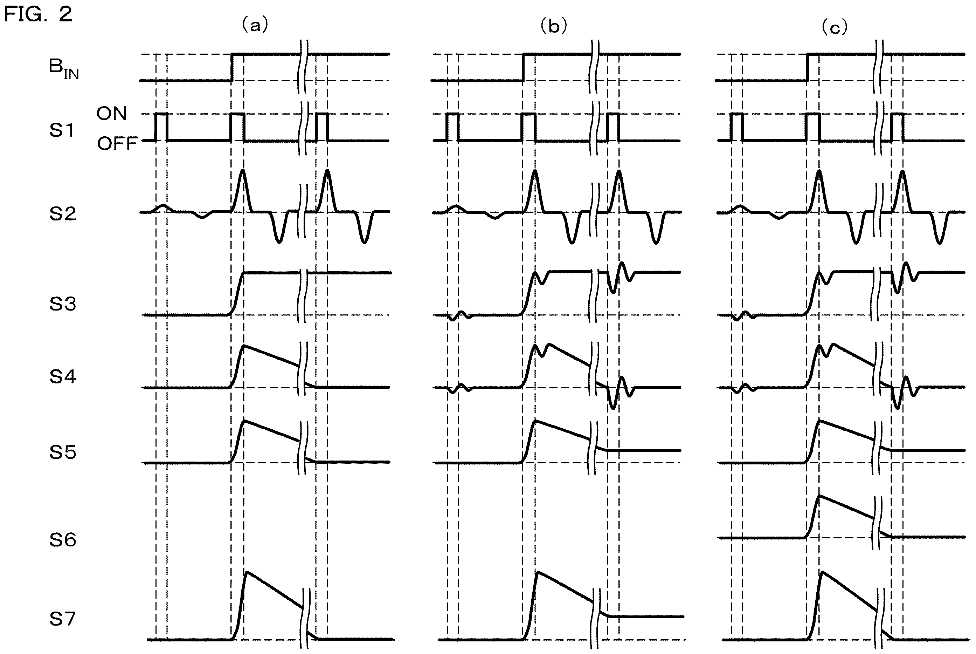

Next, the operation of the magnetic detector 1 of the present embodiment will be described with reference to Figs. 2 to 4. However, for the purpose of comparison, reference will be made to a configuration without the post-stage high-pass filter 25 in Fig. 1 in order to describe the operation of the magnetic detector 1 of the present embodiment. Specifically, an ideal behavior of the output of each unit in the configuration without the post-stage high-pass filter 25 will be described with reference to Fig. 2(a), and an actual behavior of the output of each unit in the configuration without the post-stage high-pass filter 25 will be described with reference to Fig. 2(b). Thereafter, the behavior of the output of each unit in the present embodiment will be described with reference to Fig. 2(c). In Figs. 2(a), 2(b), and 2(c), B_{IN} and S1 to S7 represent outputs of the respective units illustrated in Fig. 1.

### 1-2-1. Description of Fig. 2(a)

An ideal behavior in a configuration in which the post-stage high-pass filter 25 is not provided in the magnetic detector 1 will be described. First, as illustrated in the first row in Fig. 2(a), it is assumed to create a state where any magnetic field is applied from zero state as the magnetic field B_{IN}. In the first row in Fig. 2(a), for example, a predetermined DC magnetic field is applied as the magnetic field B_{IN}. As illustrated in the second row in Fig. 2(a), the excitation circuit 21 periodically outputs the signal S1 to turn on the sampling switch of the sample hold circuit 22. The sampling switch is turned on when the signal S1 is an ON signal, and the sampling switch is turned off when the signal S1 is an OFF signal. The signal S1 of the excitation circuit 21 is synchronized with the excitation current I_{IN} supplied to the magnetosensitive body 11.

At the timing when the excitation current I_{IN} is supplied, the change in the rise of the excitation current I_{IN} causes a magnetization change in the magnetosensitive body 11 in response to the strength of the magnetic field B_{IN} acting on the magnetosensitive body 11. The magnetization change in the magnetosensitive body 11 generates an induced voltage in the detection coil 12. An input S2 of the sample hold circuit 22 (corresponding to the output of the detection coil 12) behaves as illustrated in the third row in Fig. 2(a).

Additionally, an output S3 of the sample hold circuit 22 ideally behaves as illustrated in the fourth row in Fig. 2(a). That is, after the magnetic field B_{IN} is applied, at the time when the sampling switch is first turned on, the output S3 of the sample hold circuit 22 rises following the rise of the input S2 of the sample hold circuit 22. Thereafter, the output S3 of the sample hold circuit 22 holds its value at a constant level for a period of time when the magnetic field B_{IN} is a DC magnetic field at a constant level.

Thereby, an output S4 of the pre-stage high-pass filter 23 behaves as illustrated in the fifth row in Fig. 2(a) because the high-frequency components in the output S3 of the sample hold circuit 22 are extracted. That is, when the output S3 of the sample hold circuit 22 rises, the output S4 of the pre-stage high-pass filter 23 also rises. Thereafter, after the output S3 of the sample hold circuit 22 becomes a value at a constant level, the low-frequency component is gradually removed and the output S4 of the pre-stage high-pass filter 23 becomes a value at the level of the reference voltage after the elapse of a certain period of time.

The preamplifier 24 performs integral processing and amplification processing on the output S4 of the pre-stage high-pass filter 23. Therefore, when the output S4 of the pre-stage high-pass filter 23 behaves as illustrated in the fifth row in Fig. 2(a), an output S5 of the preamplifier 24 behaves similarly to the output S4 of the pre-stage high-pass filter 23 as illustrated in the sixth row in Fig. 2(a). The output S5 of the preamplifier 24 is inputted to the buffer amplifier 26, and thus an output S7 of the buffer amplifier 26 exhibits a behavior amplifying the output S5 of the preamplifier 24 as illustrated in the seventh row in Fig. 2(a).

### 1-2-2. Description of Fig. 2(b)

Next, an actual behavior in a configuration in which the post-stage high-pass filter 25 is not provided in the magnetic detector 1 will be described. As illustrated in the first to third rows in Fig. 2(b), the magnetic field B_{IN}, the signal S1 from the excitation circuit 21, and the input S2 of the sample hold circuit 22 are similar to those in Fig. 2(a).

The output S3 of the sample hold circuit 22 does not behave as illustrated in the fourth row in Fig. 2(a), but behaves as illustrated in the fourth row in Fig. 2(b). The first reason for this is that the sample hold circuit 22 holds the output voltage variation of the detection coil 12 during turning on the sampling switch. The second reason is that the sample hold circuit 22 holds the output voltage variation at at least one of the acquisition time or the settling time caused by on-off operation of the sampling switch.

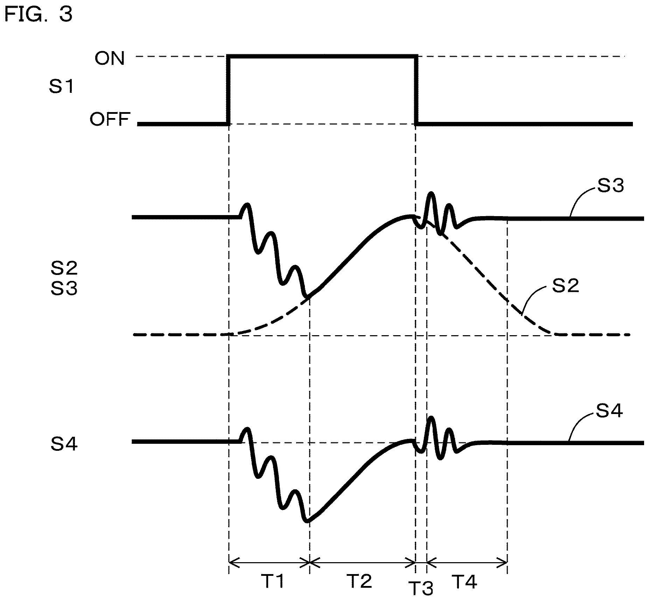

These reasons will be explained in detail with reference to Fig. 3. As illustrated in the top row in Fig. 3, the sampling switch is assumed to be turned on or off based on the signal S1 outputted from the excitation circuit 21. At this time, it is assumed that the input S2 of the sample hold circuit 22, which is the output of the detection coil 12, exhibits a behavior as illustrated by the broken line in the middle row in Fig. 3.

Then, due to characteristics of the sample hold circuit 22, as illustrated in a section T1, the sample hold circuit 22 has a period of time, that is, an acquisition time, from immediately after the sampling switch is turned on (immediately after entering a sample mode) onwards until the time at which tracking of the output voltage of the detection coil 12 (the input S2 of the sample hold circuit 22) is started. That is, in the section T1, in the output S3 of the sample hold circuit 22, an output voltage variation to approach the input S2 of the sample hold circuit 22 occurs.

Subsequently, as illustrated in a section T2, the sample hold circuit 22 tracks the output voltage of the detection coil 12 (the input S2 of the sample hold circuit 22) during the remaining period during turning on the sampling switch. Since the output voltage variation in the detection coil 12 occurs, in the section T2, the output S3 of the sample hold circuit 22 varies following the output voltage variation of the detection coil 12.

Subsequently, in the section T3, the sample hold circuit 22 has a delay time, that is, an aperture time, immediately after the sampling switch is tuned off, from the end of tracking onwards until the time at which holding is started.

Subsequently, in a section T4, when entering a hold mode, the sample hold circuit 22 has a settling time from the time when entering the hold mode onwards until the time at which the output settles down within the error range of the hold value. That is, in the section T4, the output S3 of the sample hold circuit 22 is subject to output voltage variation. After the section T4, the output S3 of the sample hold circuit 22 is held at the hold value onwards until the subsequent sample mode.

In summary, as illustrated in the middle row in Fig. 3, the output S3 of the sample hold circuit 22 varies to hold the output voltage variation of the detection coil 12 in the section T2 during turning on the sampling switch. Furthermore, the output S3 of the sample hold circuit 22 varies at at least one of the section T1 as the acquisition time or the section T4 as the settling time by an on-off operation of the sampling switch.

Returning to Fig. 2, description will be continued. For the reasons set forth above, as illustrated in the fourth row in Fig. 2(b), the output S3 of the sample hold circuit 22 does not become constant but varies even if the magnetic field B_{IN} is constant. In particular, the magnitude of variation of the output S3 of the sample hold circuit 22 depends on the magnitude of the magnetic field B_{IN}.

The output S3 of the sample hold circuit 22 is inputted to the pre-stage high-pass filter 23. As illustrated in the fourth row in Fig. 2(b) and the middle row in Fig. 3, the output S3 of the sample hold circuit 22 varies during and in the vicinity of an on-operation of the sampling switch. When the output S3 of the sample hold circuit 22 varies in this manner, the pre-stage high-pass filter 23 extracts a high-frequency component of the output S3 of the sample hold circuit 22, and thus the output S4 of the pre-stage high-pass filter 23 exhibits a behavior as illustrated in the fifth row in Fig. 2(b) and the bottom row in Fig. 3.

That is, as illustrated in the fifth row in Fig. 2(b) and the bottom row in Fig. 3, the output S4 of the pre-stage high-pass filter 23 coincides with the reference voltage (the potential indicated by the horizontal thin broken line) before the sampling switch is turned on, but varies immediately after the sampling switch is turned on, and thereafter, moves back to the reference voltage. Note that the fifth row in Fig. 2(b) and the bottom row in Fig. 3 illustrate the case where the output S4 of the pre-stage high-pass filter 23 varies in the negative direction when the sampling switch is turned on, but there may be a case where the output S4 varies in the positive direction.

Then, after a predetermined time has elapsed from the time at which the sampling switch is turned off, the output S4 of the pre-stage high-pass filter 23 coincides with the reference voltage again. In this manner, the output S4 of the pre-stage high-pass filter 23 has a transient waveform that is asymmetrical in positive and negative directions with relative to the reference voltage during and in the vicinity of an on-operation of the sampling switch.

That is, after the elapse of a certain period of time, at a portion where the output S3 of the sample hold circuit 22 does not vary, the output S4 of the pre-stage high-pass filter 23 coincides with the reference voltage, but at a portion where the output S3 of the sample hold circuit 22 varies, the same variation state remains in the output S4 of the pre-stage high-pass filter 23. In particular, at the variation portion, the output S4 of the sample hold circuit 22 has a transient waveform that is asymmetrical in positive and negative directions with relative to the reference voltage.

The preamplifier 24 performs integral processing and amplification processing on the output S4 of the pre-stage high-pass filter 23. Therefore, in a case where the output S4 of the pre-stage high-pass filter 23 has a behavior that is asymmetrical in positive and negative directions with respect to the reference voltage as illustrated in the fifth row in Fig. 2(b) and the bottom row in Fig. 3, an offset component from the reference voltage is generated in the output S5 of the preamplifier 24 after the elapse of a certain period of time as illustrated in the sixth row in Fig. 2(b).

That is, the preamplifier 24 converts, through the integral processing, the output voltage variation of the detection coil 12 during turning on the sampling switch and the output voltage variation at at least one of the acquisition time or the settling time caused by on-off operation of the sampling switch, into the offset component from the reference voltage.

The output S5 of the preamplifier 24 is inputted to the buffer amplifier 26, and thus the output S7 of the buffer amplifier 26 exhibits a behavior amplifying the output S5 of the preamplifier 24 as illustrated in the seventh row in Fig. 2(b). Therefore, the output S7 of the buffer amplifier 26 becomes in a state in which the offset component from the reference voltage remains after the elapse of a certain period of time.

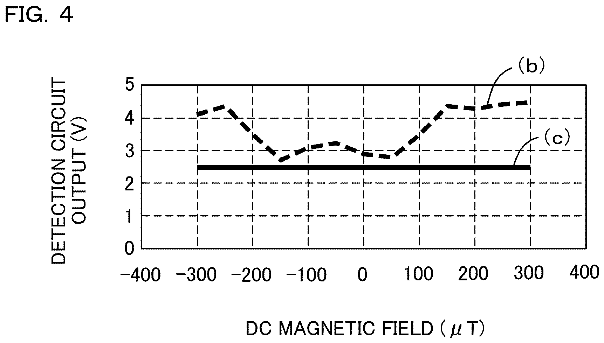

Here, as illustrated in Fig. 2(b), the relationship between the output S7 of the buffer amplifier 26 and the DC magnetic field, that is, the relationship between the output of the detection circuit 20 and the DC magnetic field is a relationship as illustrated by a broken line (b) in Fig. 4. That is, the output S7 of the buffer amplifier 26 is an offset amount at a level different from the reference voltage of 2.5 V, depending on the magnitude of the DC magnetic field. Although this relationship is not a linear relationship, the relationship is almost such that the larger the DC magnetic field, the larger the offset component of the output S7 of the buffer amplifier 26.

### 1-2-3. Description of Fig. 2(c)

Next, the behavior of each unit in the magnetic detector 1 of the present embodiment will be described. As illustrated in the first to sixth rows in Fig. 2(c), the magnetic field B_{IN}, the signal S1 from the excitation circuit 21, the input S2 of the sample hold circuit 22, the output S3 of the sample hold circuit 22, the output S4 of the pre-stage high-pass filter 23, and the output S5 of the preamplifier 24 are similar to those in Fig. 2(b). Also, in the magnetic detector 1 of the present embodiment, the same applies to behaviors illustrated in the top, middle, and bottom rows in Fig. 3.

The magnetic detector 1 of the present embodiment includes the post-stage high-pass filter 25 at a place that is on the output side of the preamplifier 24 and on the input side of the buffer amplifier 26. The post-stage high-pass filter 25 receives the output S5 of the preamplifier 24. The post-stage high-pass filter 25 extracts a high-frequency component of the output S5 of the preamplifier 24 and hence the output S6 of the post-stage high-pass filter 25 behaves as illustrated in the seventh row in Fig. 2(c). That is, the post-stage high-pass filter 25 removes the offset component after the elapse of a certain period of time from the output S5 of the preamplifier 24. Therefore, the output S6 of the post-stage high-pass filter 25 coincides with the reference voltage after the elapse of a certain period of time.

In addition, the output S6 of the post-stage high-pass filter 25 is inputted to the buffer amplifier 26, and thus the output S7 of the buffer amplifier 26 exhibits a behavior that amplifies the output S6 of the post-stage high-pass filter 25 as illustrated in the eighth row in Fig. 2(c). Therefore, the output S7 of the buffer amplifier 26 coincides with the reference voltage after the elapse of a certain period of time. That is, the output S7 of the buffer amplifier 26 in the present embodiment coincides with the output S7 of the buffer amplifier 26 in the ideal behavior, as illustrated in the seventh row in Fig. 2(a).

Here, as illustrated in Fig. 2(c), the relationship between the output S7 of the buffer amplifier 26 and the DC magnetic field, that is, the relationship between the output of the detection circuit 20 and the DC magnetic field is a relationship as illustrated by the solid line (c) in Fig. 4. That is, the output S7 of the buffer amplifier 26 is at a constant level of 2.5 V, as the reference voltage, at all times independent of the magnitude of the DC magnetic field.

### 1-3. Effects

According to the magnetic detector 1 of the present embodiment, even if an offset component affected by the DC magnetic field is included in the output S5 of the preamplifier 24, the offset component can be removed by the post-stage high-pass filter 25. Therefore, the output value of the detection circuit 20 is enabled to be made free of offset components affected by the DC magnetic field. As a result, the detection circuit 20 is less susceptible to the DC magnetic field, and can detect a minute AC magnetic field with high accuracy. As described above, the magnetic detector 1 of the present embodiment is enabled to be improved in the magnetic field detection performance.

### (Embodiment 2)

### 2-1. Configuration of magnetic detector 2

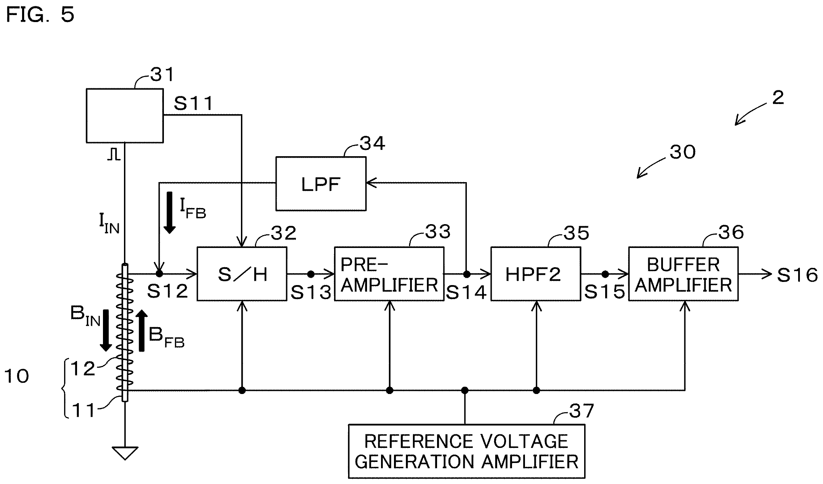

A configuration of a magnetic detector 2 in Embodiment 2 will be described with reference to Fig. 5. Note that, among the reference numerals used in Embodiment 2, the same reference numerals as those used in the aforementioned embodiment represent the same components and the like as those in the aforementioned embodiment unless otherwise specified.

As illustrated in Fig. 5, the magnetic detector 2 of the present embodiment includes an MI sensor element 10 and a detection circuit 30. The detection circuit 30 is electrically connected to the MI sensor element 10, and is configured to detect the strength of the magnetic field B_{IN} acting on the magnetosensitive body 11. The detection circuit 30 includes an excitation circuit 31, a sample hold circuit 32 ("S/H" in Fig. 1), a preamplifier 33, a feedback circuit 34, a post-stage high-pass filter 35 ("HPF2" in Fig. 1), a buffer amplifier 36, and a reference voltage generation amplifier 37.

Here, the excitation circuit 31, the sample hold circuit 32, and the reference voltage generation amplifier 37 in the present embodiment are the same as the excitation circuit 21, the sample hold circuit 22, and the reference voltage generation amplifier 27 in Embodiment 1.

The preamplifier 33 is an amplifier circuit connected to an output side of the sample hold circuit 32. The preamplifier 33 performs integral processing and amplification processing on the output of the sample hold circuit 32.

The feedback circuit 34 connects the output side of the preamplifier 33 and one end of the detection coil 12, and includes a low-pass filter. In the feedback circuit 34, a predetermined frequency component is extracted by the low-pass filter, and a feedback magnetic field B_{FB} is caused by a feedback current I_{FB} related to a predetermined frequency component. In other words, in the feedback circuit 34, the feedback magnetic field B_{FB} is caused by the feedback current I_{FB} in a predetermined frequency band passing through the low-pass filter. In the feedback circuit 34, an external magnetic field B_{IN} applied to the MI sensor element 10 is partly cancelled out by the generated feedback magnetic field B_{FB}. That is, the feedback circuit 34 causes frequency selective negative feedback of the magnetic field in the MI sensor element 10. In this case, the MI sensor element 10 cancels out the magnetic field signal in a predetermined frequency band (low frequency components, mainly DC components) by means of the frequency selective negative feedback of the magnetic field, and responds only to an AC signal other than the cancelled components.

The post-stage high-pass filter 35 is connected to the output side of the preamplifier 33 and extracts a signal in a frequency band higher than a predetermined frequency band. As the post-stage high-pass filter 35, for example, a known high-pass filter circuit such as a circuit including at least two components of LCR or a circuit using an operational amplifier such as a differential circuit can be used. Furthermore, as the post-stage high-pass filter 35, besides the above-described circuits, other configurations can also be used as long as they are capable of achieving the intended function.

The buffer amplifier 36 is an amplifier circuit connected to the output side of the post-stage high-pass filter 35. The buffer amplifier 36 performs amplification processing on an output of the post-stage high-pass filter 35. The output of the buffer amplifier 36 is the output of the detection circuit 30.

### 2-2. Operation of magnetic detector 2

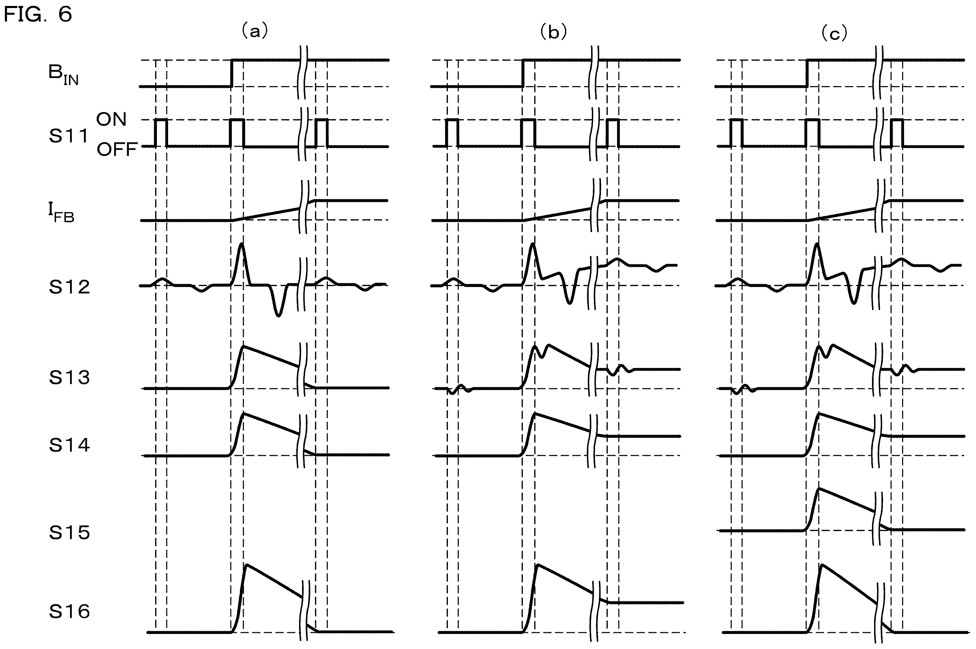

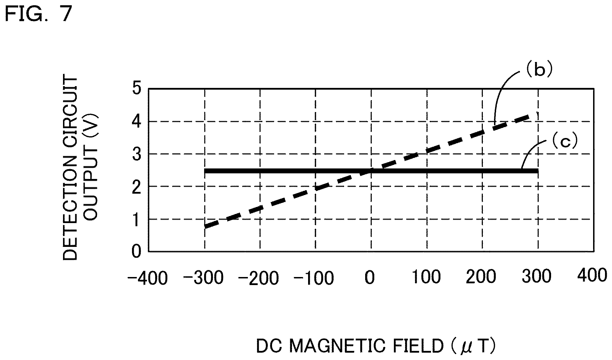

Next, the operation of the magnetic detector 1 of the present embodiment will be described with reference to Figs. 6 and 7. However, for the purpose of comparison, reference is made to a configuration without the post-stage high-pass filter 35 in Fig. 5 in order to describe the operation of the magnetic detector 2 of the present embodiment. Specifically, an ideal behavior of the output of each unit in the configuration without the post-stage high-pass filter 35 will be described with reference to Fig. 6(a), and an actual behavior of the output of each unit in the configuration without the post-stage high-pass filter 35 will be described with reference to Fig. 6(b). Thereafter, the behavior of the output of each unit in the present embodiment will be described with reference to Fig. 6(c). In Figs. 6(a), 6(b), and 6(c), B_{IN}, S11, I_{FB}, and S12 to S16 represent outputs of the respective units illustrated in Fig. 5.

### 2-2-1. Description of Fig. 6(a)

In the magnetic detector 2, an ideal behavior in a configuration without the post-stage high-pass filter 35 will be described. First, as illustrated in the first row in Fig. 6(a), it is assumed to create a state where any magnetic field is applied from zero state as the magnetic field B_{IN}. In the first row in Fig. 6(a), for example, a predetermined DC magnetic field is applied as the magnetic field B_{IN}. As illustrated in the second row in Fig. 6(a), the excitation circuit 31 periodically outputs a signal S11 to turn on the sampling switch of the sample hold circuit 32. The sampling switch is turned on when the signal S11 is an ON signal, and the sampling switch is turned off when the signal S11 is an OFF signal. The signal S11 of the excitation circuit 31 is synchronized with the excitation current I_{IN} supplied to the magnetosensitive body 11.

Here, the magnetic detector 2 of the present embodiment includes the feedback circuit 34. In the feedback circuit 34, a feedback voltage is generated from an output S14 of the preamplifier 33, and a feedback current I_{FB} corresponding to a potential difference between the feedback voltage and the reference voltage is generated. However, the feedback voltage has a response according to the time constant of the low-pass filter from the time point when the magnetic field B_{IN} is changed. After the elapse of a certain period of time, the feedback voltage becomes a voltage that can magnetically cancel out low-frequency components mainly containing DC components included in the magnetic field B_{IN}. That is, the feedback current I_{FB} increases with an increase in the feedback voltage, and behaves as illustrated in the third row in Fig. 6(a).

An input S12 of the sample hold circuit 32 ideally behaves as illustrated in the fourth row in Fig. 6(a). Before the variation of the magnetic field B_{IN}, the input S12 of the sample hold circuit 32 is approximately at the same level as the reference voltage. Immediately after the variation of the magnetic field B_{IN}, large variation occurs in the input S12 of the sample hold circuit 32 due to the induced voltage of the detection coil 12. In a case where there is no change in the magnetic field B_{IN} after the variation of the magnetic field B_{IN}, the input S12 of the sample hold circuit 32 is approximately at the same level as the reference voltage after a certain period of time elapses from the variation of the magnetic field B_{IN}. That is, the behavior of the input S12 of the sample hold circuit 32 before the variation of the magnetic field B_{IN} is almost the same as the behavior of the input S12 of the sample hold circuit 32 after the elapse of a certain period of time from the variation of the magnetic field B_{IN} and when there is no change in the magnetic field B_{IN}.

In addition, an ideal behavior of an output S13 of the sample hold circuit 32 is a behavior as illustrated in the fifth row in Fig. 6(a). That is, when the sampling switch is turned on for the first time after the variation of the magnetic field B_{IN}, the output S13 of the sample hold circuit 32 rises following the rise of the input S12 of the sample hold circuit 32. Thereafter, the voltage held by the sample hold circuit 32 gradually decreases due to the action of the feedback current I_{FB}, and thus the output S13 of the sample hold circuit 32 coincides with the reference voltage after the elapse of a certain period of time.

The preamplifier 33 performs integral processing and amplification processing on the output S13 of the sample hold circuit 32. Accordingly, when the output S13 of the sample hold circuit 32 exhibits a behavior as illustrated in the fifth row in Fig. 6(a), the behavior of the output S14 of the preamplifier 33 is almost the same as the behavior of the output S13 of the sample hold circuit 32 as illustrated in the sixth row of Fig. 6(a). In addition, since the output S14 of the preamplifier 33 is inputted to the buffer amplifier 36, an output S16 of the buffer amplifier 36 exhibits a behavior amplifying the output S14 of the preamplifier 33 as illustrated in the seventh row in Fig. 6(a).

### 2-2-2. Description of Fig. 6(b)

Next, an actual behavior in a configuration in which the post-stage high-pass filter 35 is not provided in the magnetic detector 2 will be described. As illustrated in the first to third rows in Fig. 6(b), the magnetic field B_{IN}, the signal S11 from the excitation circuit 21, and the feedback current I_{FB} are the same as those in Fig. 6(a).

The input S12 of the sample hold circuit 32 does not behave as illustrated in the fourth row in Fig. 6(a), but behaves as illustrated in the fourth row in Fig. 6(b). This is because the feedback circuit 34 is connected to one end of the detection coil 12. Because of this, the feedback circuit 34 causes the sample hold circuit 32 to hold a total voltage that is the sum of the induced voltage caused by the detection coil 12 and the feedback voltage generated by the feedback current I_{FB}. Accordingly, the input S12 of the sample hold circuit 32 increases with an increase in the feedback current I_{FB} as illustrated in the fourth row in Fig. 6(b).

The output S13 of the sample hold circuit 32 behaves as illustrated in the fifth row in Fig. 6(b). The operation of the sample hold circuit 32 is similar to the operation described with reference to Fig. 3 in Embodiment 1. That is, at the initial stage of the sample mode, the output S13 of the sample hold circuit 32 varies at the acquisition time. Thereafter, from the middle of the sample mode, the output S13 of the sample hold circuit 32 tracks the total voltage that is the sum of the induced voltage caused by the detection coil 12 and the feedback voltage. Then, the output S13 of the sample hold circuit 32 holds the hold value after an off-operation of the sampling switch and a lapse of the delay time and the settling time.

Therefore, after the elapse of a certain period of time, as illustrated in the fifth row in Fig. 6(b), in the output S13 of the sample hold circuit 32, variation caused by on-off operation of the sampling switch is added to the condition of being offset from the reference voltage due to the influence of the feedback voltage.

The preamplifier 33 performs integral processing and amplification processing on the output S13 of the sample hold circuit 32. Accordingly, when the output S13 of the sample hold circuit 32 behaves as illustrated in the fifth row in Fig. 6(b), an offset component from the reference voltage is generated in the output S14 of the preamplifier 33 after the elapse of a certain period of time, as illustrated in the sixth row in Fig. 6(b). As described above, in the output S14 of the preamplifier 33, a component of the feedback voltage is generated as an offset component after the elapse of a certain period of time.

Moreover, the preamplifier 33 converts, through the integral processing, the output voltage variation of the detection coil 12 during turning on the sampling switch and the output voltage variation at at least one of the acquisition time or the settling time caused by on-off operation of the sampling switch, into an offset component from the reference voltage. However, in the present embodiment, in the offset component in the output S14 of the preamplifier 33, the component of the feedback voltage is relatively large, and the component due to the operation of the sampling switch is relatively small.

The output S14 of the preamplifier 33 is inputted to the buffer amplifier 36, and thus the output S16 of the buffer amplifier 36 exhibits a behavior amplifying the output S14 of the preamplifier 33 as illustrated in the seventh row in Fig. 6(b). Accordingly, the output S16 of the buffer amplifier 36 is in a state where the offset component from the reference voltage remains after the elapse of a certain period of time.

Here, as illustrated in Fig. 6(b), the relationship between the output S16 of the buffer amplifier 36 and the DC magnetic field, that is, the relationship between the output of the detection circuit 30 and the DC magnetic field is a relationship as illustrated by a broken line in Fig. 7(b). That is, the output S7 of the buffer amplifier 36 has an offset amount at a level different from the reference voltage of 2.5 V, depending on the magnitude of the DC magnetic field. There is a linear relationship in which the larger the DC magnetic field, the larger the offset component of the output S7 of the buffer amplifier 26.

### 2-2-3. Description of Fig. 6(c)

Next, the behavior of each unit in the magnetic detector 2 of the present embodiment will be described. As illustrated in the first to sixth rows in Fig. 6(c), the magnetic field B_{IN}, the signal S11 from the excitation circuit 21, the feedback current I_{FB}, the input S12 of the sample hold circuit 32, the output S13 of the sample hold circuit 32, and the output S14 of the preamplifier 33 are similar to those in Fig. 6(b).

The magnetic detector 2 of the present embodiment includes the post-stage high-pass filter 35 at a place that is on the output side of the preamplifier 33 and on the input side of the buffer amplifier 36. The post-stage high-pass filter 35 receives the output S14 of the preamplifier 33. The post-stage high-pass filter 35 extracts high-frequency components in the output S14 of the preamplifier 33, and thus the output S15 of the post-stage high-pass filter 35 behaves as illustrated in the seventh row in Fig. 6(c). That is, after the elapse of a certain period of time, the post-stage high-pass filter 35 removes an offset component out of the output S14 of the preamplifier 33. Accordingly, the output S15 of the post-stage high-pass filter 35 coincides with the reference voltage after the elapse of a certain period of time.

Then, the output S15 of the post-stage high-pass filter 35 is inputted to the buffer amplifier 36, and thus the output S16 of the buffer amplifier 36 exhibits a behavior amplifying the output S15 of the post-stage high-pass filter 35 as illustrated in the eighth row in Fig. 6(c). Accordingly, the output S16 of the buffer amplifier 36 coincides with the reference voltage after the elapse of a certain period of time. That is, as illustrated in the seventh row in Fig. 6(a), the output S16 of the buffer amplifier 36 in the present embodiment coincides with the output S16 of the buffer amplifier 36 in its ideal behavior.

Here, as illustrated in Fig. 6(c), the relationship between the output S16 of the buffer amplifier 36 and the DC magnetic field, that is, the relationship between the output of the detection circuit 30 and the DC magnetic field is a relationship as illustrated by the solid line (c) in Fig. 7. That is, the output S16 of the buffer amplifier 36 is at a constant level of 2.5 V, which is the reference voltage, at all times independent of the magnitude of the DC magnetic field.

### 2-3. Effects

According to the magnetic detector 2 of the present embodiment, even if the offset component affected by the DC magnetic field is included in the output S14 of the preamplifier 33, this offset component can be removed by the post-stage high-pass filter 35. Therefore, the output value of the detection circuit 30 can be made free of any offset component affected by the DC magnetic field. As a result, in terms of the value of the DC magnetic field that can be cancelled out by the feedback current I_{FB}, the detection circuit 30 is less susceptible to the DC magnetic field and is capable of detecting a minute AC magnetic field with high accuracy. As described above, the magnetic detector 2 of the present embodiment is capable of enhancing the magnetic field detection performance.

### (First modification of Embodiment 1)

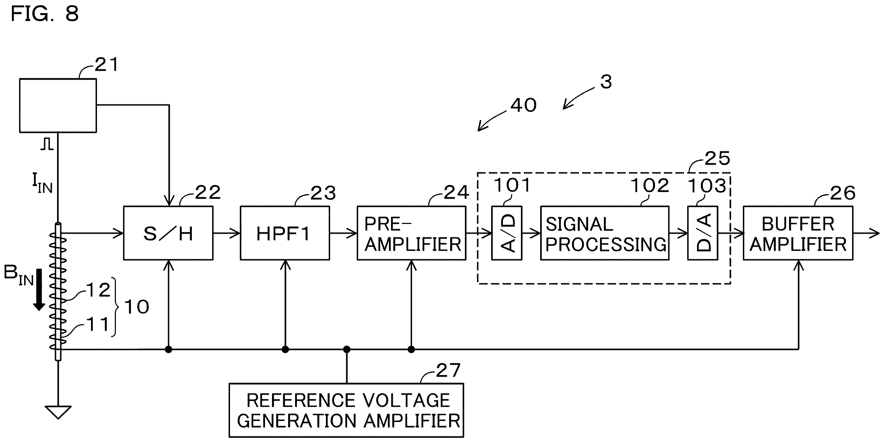

A magnetic detector 3 according to a first modification of Embodiment 1 will be described with reference to Fig. 8. The only difference of the first modification is a post-stage high-pass filter 25 of a detection circuit 40. Nonetheless, the post-stage high-pass filter 25 in the present modification has a different configuration but has the same function as that of the post-stage high-pass filter 25 of Embodiment 1.

The post-stage high-pass filter 25 in the present modification includes an A/D converter 101, a signal processing unit 102, and a D/A converter 103. The A/D converter 101 converts the output of the preamplifier 24 into a digital signal, the signal processing unit 102 performs correction processing on the digital signal including an offset component, and the D/A converter 103 converts the corrected digital signal into an analog signal.

That is, the post-stage high-pass filter 25 of the present modification includes the signal processing unit 102 that performs digital signal processing after digital conversion. For example, the signal processing unit 102 performs Fourier transform and extracts only a desired high-frequency component, and performs inverse Fourier transform on the extracted transform result, thereby enabling to remove offset components. In this case, all the offset components are removed, and hence when an amount of the reference voltage value needs to be offset, the reference voltage value is required to be added as a correction value.

Alternatively, the signal processing unit 102 may perform correction processing in which a difference between the digital signal voltage and the reference voltage is obtained and this difference is added to or subtracted from the digital signal. Furthermore, the signal processing unit 102 may perform digital filter processing as typified by an FIR filter and use the average value of this processing results or a digital value at a specific time as a reference voltage to perform correction processing.

Also in the present modification, effects similar to those of Embodiment 1 are achieved. Note that the post-stage high-pass filter 25 in the present modification is different from a high-pass filter circuit such as a circuit including at least two components of LCR, but serves as a high-pass filter, and is categorized in a concept of a high-pass filter, therefore this expression of high-pass filter is used. The same applies to the following modified embodiments.

### (Second modification of Embodiment 1)

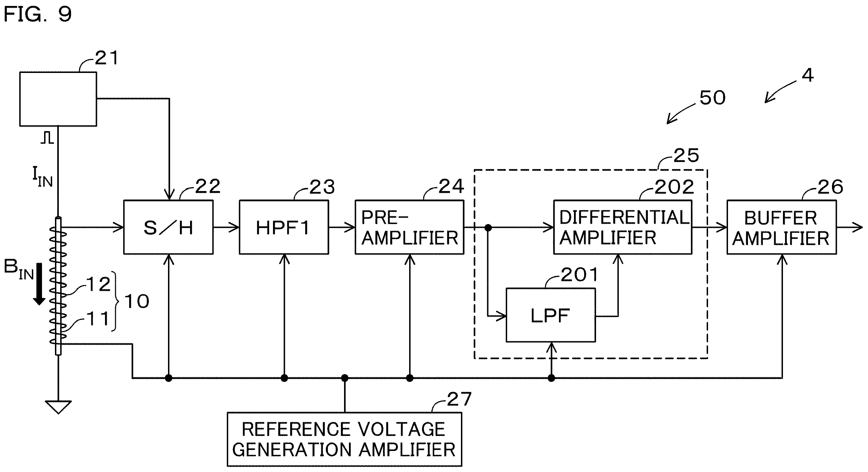

A magnetic detector 4 of a second modification of Embodiment 1 will be described with reference to Fig. 9. The only difference of the second modification is a post-stage high-pass filter 25 of a detection circuit 50. Nonetheless, the post-stage high-pass filter 25 in the present modification has a different configuration but has the same function as that of the post-stage high-pass filter 25 of Embodiment 1.

The post-stage high-pass filter 25 in the present modification includes a low-pass filter 201 and a differential amplifier 202 (corresponding to a processing unit). The low-pass filter 201 extracts a signal in a frequency band lower than a predetermined frequency band on the output of the preamplifier 24. The differential amplifier 202 subtracts a component obtained through the low-pass filter 201 on the output of the preamplifier 24 from the output of the preamplifier 24. Also in the present modification, effects similar to those of Embodiment 1 are achieved.

### (Third modification of Embodiment 1)

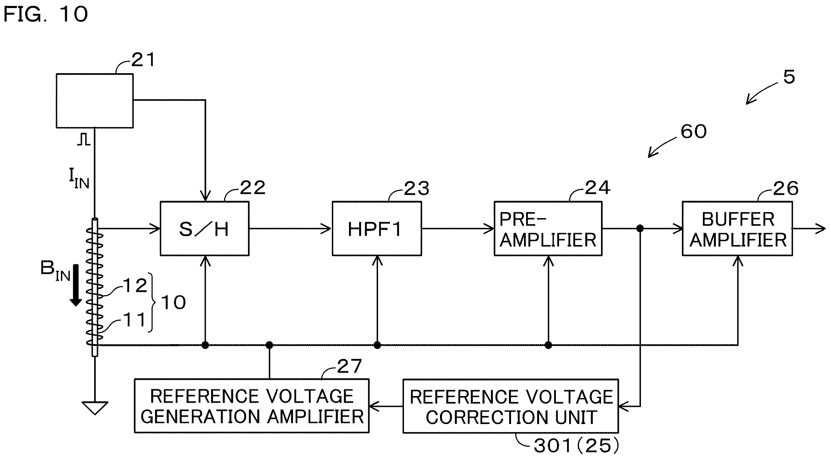

A magnetic detector 5 of a third modification of Embodiment 1 will be described with reference to Fig. 10. The only difference of the third modification is a post-stage high-pass filter 25 of a detection circuit 60. Nonetheless, the post-stage high-pass filter 25 in the present modification has a different configuration but has the same function as that of the post-stage high-pass filter 25 of Embodiment 1.

The post-stage high-pass filter 25 in the present modification functions as a reference voltage correction unit 301. The reference voltage correction unit 301 is connected to the output side of the preamplifier 24, and is configured to apply a DC component out of the output of the preamplifier 24 as a reference voltage to the preamplifier 24 and the like. Specifically, the reference voltage correction unit 301 extracts a DC component out of the output of the preamplifier 24. The reference voltage correction unit 301 corrects the reference voltage of a reference voltage generation amplifier 27 such that the extracted DC component is used as the reference voltage. The reference voltage generation amplifier 27 applies the corrected reference voltage as a reference voltage to the MI sensor element 10, the sample hold circuit 22, the pre-stage high-pass filter 23, the preamplifier 24, and the buffer amplifier 26.

In the detection circuit 60 of the present modification, the output of the preamplifier 24 is an input of the buffer amplifier 26. Also in the present modification, effects similar to those of Embodiment 1 are achieved.

### (Others)

The first to third modifications can be similarly applied to Embodiment 2.

## Claims

1. A magnetic detector comprising:
a magneto-impedance sensor element including a magnetosensitive body configured to cause a magnetization change in response to a strength of a magnetic field when an excitation current is supplied thereto, and a detection coil wound around the magnetosensitive body and configured to output an induced voltage generated by the magnetization change in the magnetosensitive body;
a sample hold circuit connected to one end of the detection coil and configured to hold an output voltage of the detection coil during turning on a sampling switch;
an amplifier circuit connected to an output side of the sample hold circuit; and
a post-stage high-pass filter connected to an output side of the amplifier circuit.

2. The magnetic detector according to claim 1, further comprising a pre-stage high-pass filter connected to an output side of the sample hold circuit,
wherein the amplifier circuit is connected to an output side of the pre-stage high-pass filter.

3. The magnetic detector according to claim 2, wherein the sample hold circuit is configured to hold output voltage variation of the detection coil during turning on the sampling switch,
the amplifier circuit is configured to perform integral processing and amplification processing on an output of the pre-stage high-pass filter, and to convert the output voltage variation into an offset component through the integral processing, and
the post-stage high-pass filter is configured to remove the offset component.

4. The magnetic detector according to claim 2, wherein the sample hold circuit is configured to hold output voltage variation at at least one of an acquisition time or a settling time caused by on-off operation of the sampling switch,
the amplifier circuit is configured to perform integral processing and amplification processing on an output of the pre-stage high-pass filter, and to convert the output voltage variation into an offset component through the integral processing, and
the post-stage high-pass filter is configured to remove the offset component.

5. The magnetic detector according to claim 2, wherein an output side of the amplifier circuit and one end of the detection coil are not connected, and no feedback circuit is provided therebetween.

6. The magnetic detector according to claim 1, further comprising a feedback circuit connecting an output side of the amplifier circuit and one end of the detection coil and including a low-pass filter.

7. The magnetic detector according to claim 6, wherein the feedback circuit is configured such that an external magnetic field applied to the magneto-impedance sensor element is partially cancelled out by a feedback magnetic field caused by a feedback current in a predetermined frequency band passing through the low-pass filter, and that the sample hold circuit is caused to hold a total voltage that is a sum of the induced voltage and a feedback voltage generated by the feedback current, and
the post-stage high-pass filter is configured to remove a component of the feedback voltage that is generated by the feedback current and is included in an output of the amplifier circuit.

8. The magnetic detector according to any one of claims 1 to 7, wherein the post-stage high-pass filter comprises any one of:
a circuit comprising at least two components of LCR;
a high-pass filter circuit including an operational amplifier;
a signal processing unit configured to perform digital signal processing after digital conversion;
a processing unit configured to subtract a component obtained through a low-pass filter on an output of the amplifier circuit from an output of the amplifier circuit; and
a reference voltage correction unit configured to apply a DC component out of an output of the amplifier circuit as a reference voltage to the amplifier circuit.
